# EUROPÄISCHE PATENTANMELDUNG

(11) **EP 3 422 828 A1**
(43) Veröffentlichungstag der Anmeldung: **02.01.2019**
(21) Anmeldenummer: 17178878.9
(22) Anmeldetag: 29.06.2017
(51) Int. Cl.: H05K 3/40, H05K 1/05

(54) **VERFAHREN UND VORRICHTUNG ZUR HERSTELLUNG EINES ELEKTRISCHEN ANSCHLUSSKONTAKTS - KONTAKTINATOR**

(71) Anmelder: voestalpine Stahl GmbH, 4020 Linz (AT)
(72) Erfinder: Atzmüller, Peter, 4020 Linz (AT); Braidt, Roland, 4202 Hellmonsödt (AT); Jakoby, Bernhard, 4040 Linz (AT); Hilber, Wolfgang, 4293 Gutau (AT); Sell, Johannes, 4030 Linz (AT); Enser, Herbert, 4040 Linz (AT)
(74) Vertreter: Jell, Friedrich

(57) **Zusammenfassung**

Es wird eine Vorrichtung (22) und ein Verfahren zur Herstellung eines elektrischen Anschlusskontakts (6) an einem beschichteten Blech (1) gezeigt, dessen Beschichtung (2) mindestens eine von einer elektrischen Isolationsschicht (5) abgedeckte elektrische Leiterbahn (4) aufweist, bei dem eine Ausnehmung (8) durch die elektrische Isolationsschicht (5) hindurch bis zumindest zur elektrischen Leiterbahn (4) hin erzeugt wird und in diese Ausnehmung (8) ein elektrisch leitendes Kontaktelement (7) vorgesehen wird, das elektrisch an einem Ende (7.2) an die Leiterbahn (4) anschließt und am anderen Ende (7.1) den elektrischen Anschlusskontakt (6) ausbildet. Um die Reproduzierbarkeit des Verfahrens zu erhöhen, wird vorgeschlagen, dass die Ausnehmung (8) mit Hilfe einer in Richtung der Leiterbahn (4) vorgeschobenen Hohlnadel (10) ausgebildet wird, die beim Zurückziehen in die Ausnehmung (8) ein elektrisch leitfähige, viskose Masse (11) einbringt, um das Kontaktelement (7) zu erzeugen.

## Beschreibung

Die Erfindung betrifft eine Vorrichtung und ein Verfahren zur Herstellung eines elektrischen Anschlusskontakts an einem beschichteten Blech, dessen Beschichtung mindestens eine von einer elektrischen Isolationsschicht abgedeckte elektrische Leiterbahn aufweist, bei welchem Verfahren eine Ausnehmung durch die elektrische Isolationsschicht bis zumindest zur elektrischen Leiterbahn hin erzeugt wird und in diese Ausnehmung ein elektrisch leitendes Kontaktelement vorgesehen wird, das elektrisch an einem Ende an die Leiterbahn anschließt und am anderen Ende den elektrischen Anschlusskontakt ausbildet.

Um eine Leiterbahn, die in einer Beschichtung auf einem Metallblech eingebettet ist, elektrisch anschließen zu können, ist es aus dem Stand der Technik bekannt (EP1517597A2) einen Kontaktstift durch die elektrische Isolierung der Beschichtung hin bis zur elektrischen Leiterbahn zu stoßen. Dadurch schließt der Kontaktstift an einem Ende an die Leiterbahn elektrisch an, wobei sein anderes Ende einen elektrischen Anschlusskontakt ausbildet. Nachteilig kann sich solch ein Einstoßen eines Kontaktstifts als vergleichsweise schwer bzw. ungenau reproduzierbar erweisen - wobei zudem stoßbedingte Verformungen am Kontaktstift eine zielgerichtete Kontaktierung erschweren können. Verfahren des Stands der Technik sind daher vergleichsweise fehleranfällig.

Es ist daher Aufgabe der Erfindung, ein Verfahren zur Herstellung eines elektrischen Anschlusskontakts an einem beschichteten Blech der eingangs geschilderten Art zu vereinfachen bzw. zu verbessern - und damit die Reproduzierbarkeit des Verfahrens zu erhöhen.

Die Erfindung löst die gestellte Aufgabe hinsichtlich des Verfahrens dadurch, dass die Ausnehmung mit Hilfe einer in Richtung der Leiterbahn vorgeschobenen Hohlnadel ausgebildet wird, die bei deren Zurückziehen aus der Ausnehmung eine elektrisch leitfähige, viskose Masse in diese Ausnehmung einbringt, um das Kontaktelement zu erzeugen.

Wird die Ausnehmung mit Hilfe einer in Richtung der Leiterbahn vorgeschobenen Hohlnadel ausgebildet, kann unabhängig von der mechanischen Festigkeit eines Kontaktelements eine positionsgenaue und im Verlauf vergleichsweise exakte Ausnehmung in der Beschichtung geschaffen werden, welche die Beschichtung bis zur Leiterbahn hin öffnet. Unter anderem werden dadurch auch Kurzschlüsse, beispielsweise mit anderen Leiterbahnen, vermieden. Wird in solch einer Ausnehmung anschließend das Kontaktelement vorgesehen, indem die Hohlnadel beim Zurückziehen aus der Ausnehmung in die Ausnehmung eine elektrisch leitfähige, viskose Masse einbringt, um das Kontaktelement zu erzeugen, kann die exakte Ausnehmung zur genauen Formgebung des Kontaktelements genützt werden - und damit auch eine in ihren elektrischen Eigenschaften gleiche elektrische Verbindung zwischen dem äußeren Anschlusskontakt und der elektrischen Leiterbahn reproduzierbar zur Verfügung gestellt werden. Zudem ist dieses Vorschieben bzw. Zurückziehen einer Hohlnadel vergleichsweise einfach handhabbar, was die Reproduzierbarkeit des Verfahrens weiter erhöhen kann.

Die Reproduzierbarkeit des Verfahrens kann weiter erhöht werden, wenn als viskose Masse eine Paste oder eine Tinte eingebracht wird.

Im Allgemeinen wird erwähnt, dass als elektrisch leitfähige Paste/Tinte zur Ausbildung des Kontaktelements ein elektrisch leitfähiges Polymer, beispielsweise Polyanilin, Polypyrrol oder Polythiophen, verwendet werden kann. Solch eine Paste/Tinte kann stattdessen auch eine metallische Basis, wie beispielsweise Silber, Kupfer oder Gold, eine organische Basis, wie beispielsweise PEDOT ((Poly- 3,4-ethylendioxythiophene) oder eine Graphen-Basis aufweisen. Ebenso ist hierfür Carbon oder Graphit denkbar. Tinten/Pasten mit metallischer Basis können sich durch eine besonders günstige Leitfähigkeit auszeichnen, wohingegen Tinten und/oder Pasten mit organischer Basis zumeist eine erhöhte Korrosionsbeständigkeit bieten können. Eine Paste weist im Allgemeinen eine höhere Viskosität auf, beispielsweise > 50 mPa·s, bevorzugt > 1 Pa·s, als eine Tinte. Beispielsweise kann PEDOT:PSS als Tinte als auch als Paste hergestellt werden. Dies ist beispielsweise über die Menge an Lösungsmittel, wie beispielsweise Wasser oder Isopropanol, einstellbar.

Die Kontaktierung der Leiterbahn kann weiter verbessert werden, wenn beim Vorschieben der Hohlnadel zumindest eine Messgröße, welche vom Abstand zwischen Hohlnadel und Leiterbahn abhängt, gemessen wird, um die Vorschubtiefe der Hohlnadel in Richtung des Blechs zu begrenzen. Damit kann die Tiefe der Ausnehmung selbst bei variierenden Beschichtungsdicken besonders exakt bestimmt und eingestellt werden - was wiederum die Reproduzierbarkeit des Verfahrens erhöhen kann.

Die Vorschubtiefe kann beispielsweise reproduzierbar eingestellt werden, wenn diese Messgröße, welche von einer der Dielektrizitätskonstanten zwischen Hohlnadel und Leiterbahn abhängt, gemessen wird.

Alternativ ist vorstellbar, dass die Vorschubtiefe dadurch eingestellt wird, in dem eine vom Wirbelstromprinzip abhängige Messgröße gemessen wird.

Auch kann die Vorschubtiefe dadurch exakt eingestellt werden, in dem eine vom induktiven Messprinzip abhängige Messgröße gemessen wird.

Durchstößt die Hohlnadel die elektrische Isolationsschicht, kann durch Verdrängung der Beschichtung - selbst bei einem eventuellen Schwinden des Kontaktelements durch Härten bzw. Trocknen der viskosen Masse eine exakte Lagefixierung des Kontaktelements sichergestellt bleiben.

Eine widerstandsarme Kontaktierung der Leiterbahn kann erreicht werden, wenn die Hohlnadel bis auf die dem Blech zugewandte Leiterseite der elektrischen Leiterbahn vorgeschoben wird. Dies kann die Reproduzierbarkeit des Verfahrens weiter erhöhen.

Ein standfester elektrischer Anschlusskontakt kann erzeugt werden, wenn die viskose Masse getrocknet und/oder gehärtet wird, um ein festes Kontaktelement zu erzeugen.
Das Härten und/oder Trocknen der Masse kann hierbei direkt nach der Einbringung aktiv oder passiv erfolgen. Bei einer passiven Aushärtung, wie beispielsweise bei einer Silberpaste, wird diese an Luft gehärtet und/oder getrocknet, ohne dies aktiv zu beschleunigen. Ein derartiger Verfahrensschritt ist vergleichsweise einfach zu handhaben, was die Reproduzierbarkeit des Verfahrens erhöhen kann. Vorzugsweise wird ein passives Härten und/oder Trocknen bei pastösen viskosen Massen, nämlich Pasten, durchgeführt, da diese resistenter gegenüber unerwünschten Formänderung an der Ausnehmung, beispielsweise durch ein Rückspringen und/oder Zurückfließen der elektrischen Isolationsschicht, sind.

Eine aktive Härtung und/oder Trocknung kann durch eine UV-Bestrahlung oder Beheizung der eingebrachten leitfähigen Paste erfolgen. Vor allem bei niedrigviskosen Tinten ist eine aktive Härtung von Vorteil. Dabei kann beispielsweise direkt nach der Einbringung und/oder während des Zurückziehens der Hohlnadel die viskose Masse mit UV-Strahlen beaufschlagt. Solch eine aktive Härtung und/oder Trocknung bietet sich besonders bei niedrigviskosen Massen an, wie beispielsweise bei Tinten, da diese besonders anfällig gegenüber einer unerwünschten Formänderung an der Ausnehmung sind.
Alternativ kann eine thermische Behandlung mit beispielsweise einem Infrarot-Lampenfeld bei 40°C bis 150°C bevorzugt 60°C bis 100°C für insbesondere 0,5 bis 100 Sekunden bevorzugt 5 bis 60 Sekunden vorgesehen sein, um damit die Aushärtung beschleunigen zu können.

Wird vor dem Einbringen der viskosen Masse diese in der Hohlnadel vorgetrocknet und/oder vorgehärtet, kann dies der Formgenauigkeit des Kontaktelements dienlich sein. Solch eine "in-situ" Härtung kann beispielsweise elektrochemisch erfolgen. Vorstellbar ist hierbei über eine Kontaktstelle an der Leiterbahn zur Hohlnadel hin elektrische Energie zu übertragen, wodurch die viskose Masse beispielsweise in der chemischen Reaktion zur Aushärtung angeregt werden kann. Vorstellbar ist zudem, dass diese elektrische Anregung in der Hohlnadel selbst erfolgt. Vorteilhafterweise kann hiermit die Geschwindigkeit der Aushärtereaktion über die Regelung des Stroms direkt und verhältnismäßig einfach gesteuert werden.

Die Formgenauigkeit des Kontaktelements kann weiter verbessert werden, wenn die viskose Masse derart vorgetrocknet und/oder vorgehärtet wird, dass diese viskose Masse von innen nach außen eine zunehmende Härte aufweist. Des Weiteren kann diese Aushärtung vermehrt an der Grenzfläche das Verfahren effizient und reproduzierbar machen und auch die Formstabilität der eingebrachten Paste weiter erhöhen. Hinzu kommt, dass eine derartige Vortrocknung und/oder Vorhärtung ein Spiel zwischen der Ausnehmung und dem Kontaktelement schaffen kann, in welche Kavität gegebenenfalls elektronische/elektrische Bauelemente/teile oder andere Materialien vorsehbar sind.

Die Erfindung hat sich außerdem die Aufgabe gestellt, eine Vorrichtung zu schaffen, mit der ein elektrischer Anschlusskontakt an einem beschichteten Blech standfest hergestellt werden kann.

Die Erfindung löst die gestellte Aufgabe mit mindestens einer Hohlnadel, die eine viskose Masse aufnimmt und wenigstens einen Sensor zur Erfassung von mindesten einer zur Hohlnadel abstandsabhängige Messgröße aufweist.

Nimmt die Hohlnadel eine viskose Masse auf und weist die Hohlnadel wenigstens einen Sensor zur Erfassung von mindestens einer zur Hohlnadel abstandsabhängigen Messgröße auf, kann ein vergleichsweise einfach konstruiertes Mittel zur Verfügung stehen, mit dem zuverlässig ein elektrischer Anschlusskontakt erstellt werden kann.

Ein in der Herstellung eines elektrischen Anschlusskontakts an einem beschichteten Blech verfahrensschnelle Vorrichtung kann geschaffen werden, wenn die Vorrichtung mehrere parallel geführte Hohlnadeln zur gemeinsamen Erzeugung von mehrere elektrische Anschlusskontakten aufweist.

In den Figuren sind beispielsweise Verfahrensschritte des erfindungsgemäßen Verfahrens dargestellt. Es zeigen
- Fig. 1: eine Schnittansicht auf ein beschichtetes Blech mit in dessen Beschichtung eingedrungenen Hohlnadel,
- Fig. 2: eine Schnittansicht auf das nach Fig. 1 dargestellte Blech mit zurückgezogener Hohlnadel,
- Fig. 3: eine Schnittansicht auf das nach Fig. 1 dargestellte Blech mit einem Anschlusskontakt und
- Fig. 4: eine abgerissene und vergrößerte Schnittansicht auf die Hohlnadel nach Fig. 1.

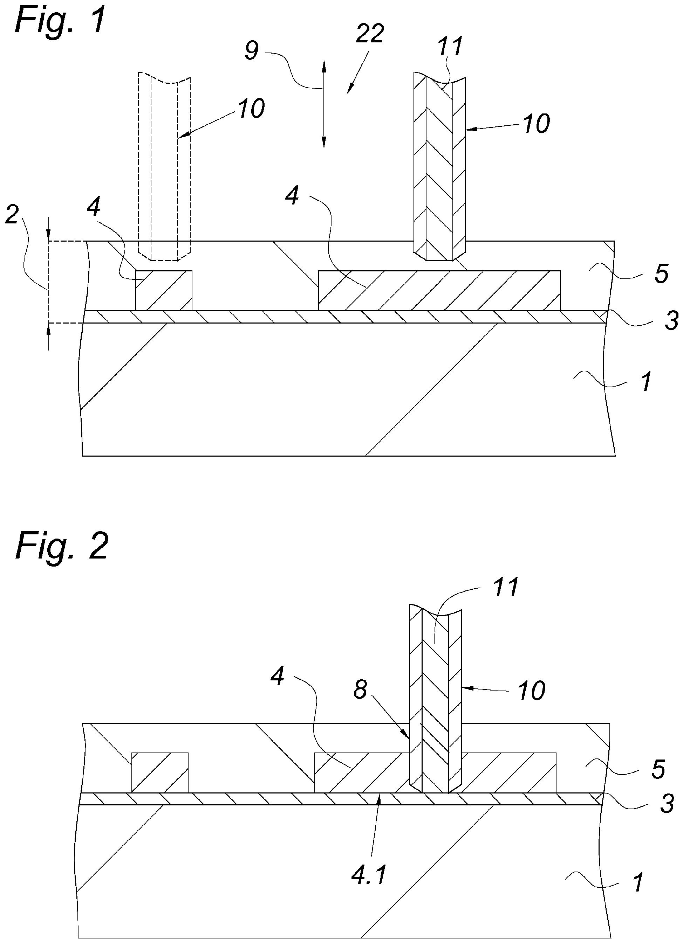

Nach den Figuren 1, 2 und 3 wird ein Blech 1, vorzugsweise Feinblech, insbesondere aus einem Stahlwerkstoff, gezeigt, welches Blech 1 mit einer Beschichtung 2 versehen ist. Diese Beschichtung 2 besteht aus einer auf das Blech 1 aufgebrachten Grundierung 3, beispielsweise Primer, einer an der Grundierung vorgesehenen elektrische Leiterbahn 4 und einer elektrischen Isolationsschicht 5, beispielsweise ein Decklack, der die Leiterbahn 4 nach außen abdeckt.

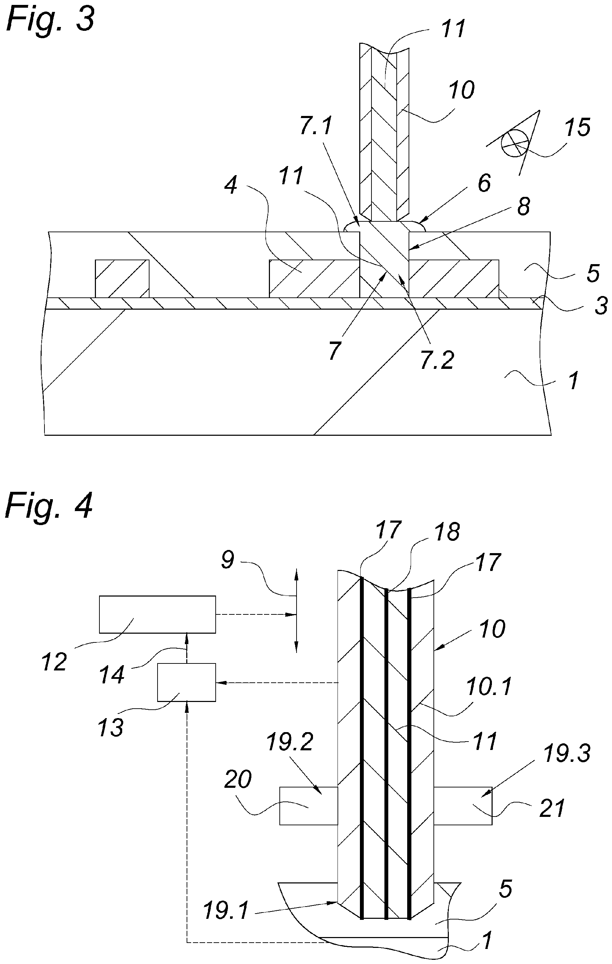

Zudem ist in Fig. 3 ein elektrischer Anschlusskontakt 6 zuerkennen, über welchen die Leiterbahn 4 elektrisch angeschlossen werden kann. Der elektrische Anschlusskontakt 6 wird von einem elektrisch leitenden Kontaktelement 7 ausgebildet. Das Kontaktelement 7 ragt hierzu durch eine Ausnehmung 8 in der elektrischen Isolationsschicht 5 bis zur elektrischen Leiterbahn 4 und kontaktiert somit die Leiterbahn 4. Dadurch ist das Kontaktelement 7 an einem ersten Ende 7.1 mit der Leiterbahn 4 elektrisch verbunden, wobei das Kontaktelement 7 am anderen zweiten Ende 7.2 den elektrischen Anschlusskontakt 6 ausbildet.

Erfindungsgemäß wird die Ausnehmung 8 in besonderer Weise erzeugt, nämlich, mit Hilfe einer in Richtung 9 der Leiterbahn 4 vorgeschobenen Hohlnadel 10 - wie dies in den Figuren 1 und 2 zu erkennen ist. Entsprechend der Fig. 1 ist die Hohlnadel 10 in die Beschichtung 2 eingedrungen - nach Fig. 2 ist diese Hohlnadel 10 bereits bis zur Leiterbahn 4 vorgeschoben dargestellt.

Durch diese Einbringung der Hohlnadel 10 ergibt sich eine besonders exakt verlaufende Ausnehmung 8 in der Beschichtung 2 bzw. in der elektrischen Isolationsschicht 5.
Beim Zurückziehen der Hohlnadel 10 aus der Ausnehmung 8 heraus, bringt die Hohlnadel 10 in diese Ausnehmung 8 eine elektrisch leitfähige viskose Masse 11, nämlich eine Paste, ein, welche das feste Kontaktelement 7 in der Ausnehmung 8 erzeugt, beispielsweise durch Aushärten und/oder Trocknen, etc. der Masse 11. Die zurückgezogene Position der Hohlnadel 10 kommt in Fig. 3 zum Ausdruck.
Da die Hohlnadel 10 vergleichsweise einfach handhabbar ist und durch die exakt verlaufende Ausnehmung 8 auch ein positionsgenaues Kontaktelement 7 für einen elektrischen Anschlusskontakt 6 am beschichteten Blech 1 erzeugt werden kann, zeichnet sich die Erfindung gegenüber dem Stand der Technik durch hohe Reproduzierbarkeit aus.
Zudem kann in der Schaffung der Ausnehmung 8 durch die Hohlnadel 10 und der Einbringung der leitfähigen viskosen Masse 11 in diese Ausnehmung 8 beim Zurückziehen der Hohlnadel 10 das Verfahren kontinuierlich ablaufen, was es beschleunigt und auch effizienter gestaltet.

Die Eindringtiefe der Hohlnadel 10 in die Beschichtung 2 wird von einer Steuerung 12 eingestellt, welche den Vorschub 9 der Hohlnadel 10 regelt/steuert. Hierzu ist der Steuerung 12 eine Messeinrichtung 13 zugeordnet, die der Steuerung 12 eine von einer der Dielektrizitätskonstanten zwischen Hohlnadel 10 und Blech 1 abhängende Messgröße 14 übermittelt. Über diese Messung, welche beispielsweise eine Kapazitätsmessung unter Verwendung des elektrisch leitfähigen Mantels 16 der Hohlnadel 10 als Sensor 19.1, sein kann, ist der Abstand der Hohlnadelspitze vom Blech 1 ermittelbar - womit die Vorschubtiefe der Hohlnadel 10 in Richtung des Blechs 1 begrenzt bzw. exakt eingestellt werden kann.

Alternativ oder zusätzlich zu diesem kapazitiv wirkenden, ersten Sensor 19.1 der Hohlnadel 10 nach Fig. 4 sind auch der Hohlnadel 10 zugehörige induktive und/oder nach dem Wirbelstromprinzip wirkende Sensoren 19.2, 19.3 denkbar, wie diese in Fig. 4 angedeutete zu erkennen sind, um damit die Abstandsmessung zuverlässig vornehmen zu können.
Hierzu weist die Hohlnadel nach Fig. 4 eine erste elektrische Spule 20 als zweiten Sensor 19.2 auf, welche erste Spule 20 außen am Mantel 16 der Hohlnadel 10 angebracht ist. Mit Hilfe dieser ersten Spule 20 werden Wirbelströme in der Leiterbahn und/oder Blech induziert. Auf Basis der Änderung der Impedanz der ersten Spule 20 kann die elektromagnetische Abschirmung des Blechs 1 durch die darüberlegende Leiterbahn 4 detektiert und in Folge dessen auf den Abstand der Hohlnadel 10 zur Leiterbahn 4 geschlossen werden.
Alternativ oder zusätzlich kann die Hohlnadel 10 einen am Mantel 16 außen vorgesehene, zweite elektrische Spule 21 als dritter Sensor 19.3 aufweisen. Die erste Spule 20 dient bei dieser Messmethode zur Erzeugung eines Magnetfeldes. Mit Hilfe der zweiten Spule 21 wird eine Spannung, die proportional zum von der ersten Spule 20 erzeugten magnetischen Fluss ist, gemessen. Da es durch die in der Beschichtung 2 eingebettete Leiterbahn 4 zu einer Veränderung des magnetischen Flusses kommt, kann anhand der Spannung an der zweiten Spule 21 die verdeckte Leiterbahn aufgefunden und auch der Abstand der Hohlnadel 10 zur Leiterbahn 4 berechnet werden.

Wie in den Figuren 1 und 2 zu erkennen, durchstößt die Hohlnadel 10 die elektrische Isolationsschicht 5, um die Ausnehmung 8 zu bilden. Es ist aber auch vorstellbar, dass die Hohlnadel 10 ein spanendes Verfahren zur Ausbildung der Ausnehmung 8 verwendet. Hierzu kann die Hohlnadel 10 mindestens eine nicht näher dargestellte Schneide aufweisen, beispielsweise von einer Wendeschneidplatte. Die nicht näher dargestellte Schneide kann am Mantel 16 und/oder am Kopf der Hohlnadel 10 vorgesehenen sein, die elektrische Isolationsschicht 5 zu zerspanen.

Ein sicherer elektrischer Kontakt mit geringem Widerstand wird geschaffen, indem die Hohlnadel 10 bis zur dem Blech 1 zugewandte Leiterseite 4.1 der elektrischen Leiterbahn 4 vorgeschoben wird.

Die viskose Masse 11 wird mit einer Strahlungsquelle 15, nämlich einer UV-Lampe, gehärtet, wodurch ein festes und damit formstabiles Kontaktelement 7 erzeugt wird. Alternativ oder zusätzlich kann zur UV-Lampe eine thermische Wärmequelle wie beispielsweise ein IR-Lampenfeld vorgesehen sein. Die Verfestigung (z. B.: Trocknung, Härtung, chemische Vernetzung, etc.) der viskose Masse 11 kann während und/oder nach der Einbringung der viskosen Masse 11 in die Ausnehmung 8 vorgenommen werden. Auch ist vorstellbar, dass die Verfestigung der viskosen Masse 11 in einem, der Herstellung eines elektrischen Anschlusskontakts 6 nachfolgenden Verfahrensschritt erfolgt.

Zudem wird -wie in Fig. 4 im Detail zu erkennen- vor dem Einbringen der viskosen Masse 11 diese in der Hohlnadel 10 vorverfestigt, nämlich durch Vernetzen vorgehärtet. Hierzu weist die Hohlnadel am Mantel 16 innenliegend eine elektrisch isolierende Beschichtung 17 auf. In der Hohlnadel 10 ist zudem zentrisch eine Elektrode 18, z. B. ein Pt-Draht, vorgesehen, die mit dem elektrisch leitenden Mantel 16 als Gegenelektrode zusammenwirkt, beim Anlegen von elektrischer Energie zwischen den beiden Elektroden eine chemische Härtungsreaktion (z. B.: Polymerisation) an der viskosen Masse 11 anzuregen. Damit kann eine in-situ Aushärtung der viskosen Masse 11 vor einem Einbringen in die Ausnehmung 8 bereits vorgenommen werden. Insbesondere kann dadurch die viskose Masse 11 derart vorgetrocknet und/oder vorgehärtet werden, dass diese Masse 11 eine innen nach außen eine zunehmende Härte aufweist.

Eine Vorrichtung 22 zur parallelen Herstellung von mehreren elektrischen Anschlusskontakten 6 ist zudem in Fig. 1 angedeutet zu erkennen. Hier werden mehrere Hohlnadeln 10 von der Vorrichtung 22 parallel geführt, und zwar mit gleichem Vorschub 9. Die Hohlnadeln 10 sind voneinander beabstandet am Blech 1 positioniert, beispielsweise nach- und nebeneinander und können damit beispielsweise die Anschlusskontakte 6 einer nicht näher dargestellte elektrischen Schnittstelle schaffen. Dies kann in einer einfach handhabbaren und effizienten Art und Weise verfahrensschnell eine Schnittstelle schaffen.

Im Allgemeinen wird weiter erwähnt, dass die Form der Hohlnadel stumpf oder spitz zulaufend sein kann. Bei einem stumpfen Eindringen wird die elektrische Isolationsschicht einer möglichst geringen Belastung ausgesetzt, wohingegen bei einer spitz zulaufenden Form die Eindringkraft reduziert werden kann. Des Weiteren kann bei einer stumpfen Form die Erfassung von Messdaten erleichtern und damit das Verfahren präziser gestalten.

## Patentansprüche

1. Verfahren zur Herstellung eines elektrischen Anschlusskontakts (6) an einem beschichteten Blech (1), dessen Beschichtung (2) mindestens eine von einer elektrischen Isolationsschicht (5) abgedeckte elektrische Leiterbahn (4) aufweist, bei welchem Verfahren eine Ausnehmung (8) durch die elektrische Isolationsschicht (5) bis zumindest zur elektrischen Leiterbahn (4) hin erzeugt wird und in diese Ausnehmung (8) ein elektrisch leitendes Kontaktelement (7) vorgesehen wird, das elektrisch an einem Ende (7.2) an die Leiterbahn (4) anschließt und am anderen Ende (7.1) den elektrischen Anschlusskontakt (6) ausbildet, **dadurch gekennzeichnet, dass** die Ausnehmung (8) mit Hilfe einer in Richtung der Leiterbahn (4) vorgeschobenen Hohlnadel (10) ausgebildet wird, die bei deren Zurückziehen aus der Ausnehmung (8) eine elektrisch leitfähige, viskose Masse (11) in diese Ausnehmung (8) einbringt, um das Kontaktelement (7) zu erzeugen.

2. Verfahren nach Anspruch 1, **dadurch gekennzeichnet, dass** als viskose Masse (11) eine Paste oder eine Tinte eingebracht wird.

3. Verfahren nach Anspruch 1 oder 2, **dadurch gekennzeichnet, dass** beim Vorschieben der Hohlnadel (10) zumindest eine Messgröße (14), welche vom Abstand zwischen Hohlnadel (10) und Leiterbahn (4) abhängt, gemessen wird, um die Vorschubtiefe der Hohlnadel (10) in Richtung des Blechs (1) zu begrenzen.

4. Verfahren nach Anspruch 3, **dadurch gekennzeichnet, dass** eine Messgröße (14), welche von einer der Dielektrizitätskonstanten zwischen Hohlnadel (10) und Leiterbahn (4) abhängt, gemessen wird.

5. Verfahren nach Anspruch 3, **dadurch gekennzeichnet, dass** eine vom Wirbelstromprinzip abhängige Messgröße (14) gemessen wird.

6. Verfahren nach Anspruch 3, **dadurch gekennzeichnet, dass** eine vom induktiven Messprinzip abhängige Messgröße (14) gemessen wird.

7. Verfahren nach einem der Ansprüche 1 bis 6, **dadurch gekennzeichnet, dass** die Hohlnadel (10) die elektrische Isolationsschicht (5) durchstößt.

8. Verfahren nach einem der Ansprüche 1 bis 7, **dadurch gekennzeichnet, dass** die Hohlnadel (10) bis auf die dem Blech (1) zugewandte Leiterseite (4.1) der elektrischen Leiterbahn (4) vorgeschoben wird.

9. Verfahren nach einem der Ansprüche 1 bis 8, **dadurch gekennzeichnet, dass** die viskose Masse (11) getrocknet und/oder gehärtet wird, um ein festes Kontaktelement (7) zu erzeugen.

10. Verfahren nach Anspruch 9, **dadurch gekennzeichnet, dass** vor dem Einbringen der viskosen Masse (11) diese in der Hohlnadel (10) vorgetrocknet und/oder vorgehärtet wird.

11. Verfahren nach Anspruch 10, **dadurch gekennzeichnet, dass** viskose Masse (11) derart vorgetrocknet und/oder vorgehärtet wird, dass diese viskose Masse (11) von Innen nach Außen eine zunehmende Härte aufweist.

12. Vorrichtung zur Durchführung des Verfahrens nach einem der Ansprüche 1 bis 11 mit mindestens einer Hohlnadel (10), die eine viskose Masse (11) aufnimmt und wenigstens einen Sensor (19.1, 19.2, 19.3) zur Erfassung von mindestens einer zur Hohlnadel (10) abstandsabhängigen Messgröße (14) aufweist.

13. Vorrichtung nach Anspruch 12, **dadurch gekennzeichnet, dass** die Vorrichtung (22) mehrere parallel geführte Hohlnadeln (10) zur gemeinsamen Erzeugung von mehrere elektrische Anschlusskontakten (6) aufweist.
